# FASCICULE DE BREVET EUROPEEN

(11) **EP 0 562 963 B1**
(45) Date de publication et mention de la délivrance du brevet: **18.09.1996**
(21) Numéro de dépôt: 93400766.7
(22) Date de dépôt: 24.03.1993
(51) Int. Cl.: H03G 3/20

(54) **Dispositif de commande de gain dans un récepteur de signaux d'information**
Verfahren zur Verstärkungsregelung in einem Empfänger für Datensignale
AGC device in a receiver for data signals

(30) Priorité: 27.03.1992 FR 9203754
(43) Date de publication de la demande: 29.09.1993
(73) Titulaire: ALCATEL TELSPACE, F-92734 Nanterre Cédex (FR)
(72) Inventeur: Podolak, Thierry, F-92300 Levallois-Perret (FR); Lopez, Pierre, F-92300 Levallois-Perret (FR)
(74) Mandataire: Pothet, Jean Rémy Emile Ludovic

(56) Documents cités:
- US-A- 4 330 859
- US-A- 4 551 688
- US-A- 4 574 252

## Description

Le domaine de l'invention est celui des récepteurs de signaux d'information et, plus particulièrement, celui des récepteurs de signaux d'information à forte dynamique, qui nécessitent un ajustement de l'amplitude du signal reçu avant que celui-ci puisse faire l'objet de tout traitement.

L'invention trouvera notamment application dans les récepteurs de systèmes dits à "Accès Multiples à Répartition dans le Temps", ou AMRT. Un système AMRT est par exemple appliqué dans le système de radiotéléphonie cellulaire numérique dit GSM. Dans un tel système, des stations mobiles permettent des communications par voie hertzienne avec des stations fixes, dites stations de base, qui sont connectées au réseau de télécommunications classique. La communication entre une station fixe et des stations mobiles qui se trouvent dans sa zone de couverture a lieu sur un canal de fréquence bilatéral partagé entre plusieurs stations mobiles par division dans le temps, un intervalle de temps d'une trame répétitive étant alloué à chaque station mobile. L'ensemble des intervalles de temps de ces trames répétitives, qui sont ainsi alloués à une station mobile, est souvent appelé voie temporelle. Dans le sens station mobile vers station fixe, chaque station mobile transmet un paquet d'information dans chaque intervalle de temps qui lui est alloué, avec le niveau qui lui est propre. A la réception dans la station fixe, les paquets en provenance de diverses stations mobiles, qui se suivent dans les intervalles de temps de chaque trame, n'ont pas tous la même amplitude. En raison de conditions de propagation variées (distances différentes, obstacles, etc...), ils ont des amplitudes qui se distribuent dans ce qu'il est convenu d'appeler une forte dynamique, pouvant atteindre, par exemple, 90 dB.

Il est nécessaire que de telles différences de niveau soient compensées dès l'entrée du récepteur de la station fixe, afin d'éviter toute saturation des équipements assurant en aval le traitement du signal reçu. Un objectif raisonnable est par exemple de ramener la dynamique de 90 à 20 dB environ.

Cette compensation opérera une correction d'amplitude constante dans chaque intervalle de temps de voie temporelle dans les cas où, tel celui du système GSM, l'amplitude des signaux d'un paquet véhicule une information exploitée à la réception. Mais, dans d'autres cas, la correction d'amplitude pourra varier dans le cours d'un intervalle de temps.

Un premier dispositif connu utilisable à cet effet comprend un amplificateur à gain variable dont le gain est commandé par une boucle de contre-réaction de niveau: le niveau de sortie de l'amplificateur est comparé à un niveau de référence et tout écart donne lieu à un signal de commande de gain appliqué à l'amplificateur à gain variable et tendant à maintenir le niveau de sortie de celui-ci voisin du niveau de référence. Un autre type de dispositif est divulgué dans le document US-A-4 551 688

Un tel dispositif ne convient pas dans les cas tels que les systèmes de type AMRT où des variations brutales de niveau entre la fin d'un intervalle de temps et le début du suivant exigeraient une très large bande passante, d'où des risques d'instabilité, ce qui nécessiterait des précautions coûteuses.

Un autre dispositif connu, décrit dans le document EP-0.369.830-A2, utilise également un amplificateur à gain variable, mais le signal de commande de gain, au lieu de dépendre de l'écart entre le niveau du signal reçu et un niveau de référence, est plutôt de type prédictif: il dépend de l'écart dans le temps entre le moment de la réception d'un paquet dans un intervalle de temps et le moment auquel typiquement ce paquet devrait être reçu. En bref, plus le signal est tardif, plus il vient de loin, donc plus son niveau est supposé faible, et le gain est ajusté en conséquence. Il est clair qu'un tel principe convient seulement si les stations mobiles ne règlent pas leur synchronisation de manière à supprimer les effets de la distance et si la transmission n'a lieu qu'en espace libre. Il n'est donc pas applicable au système GSM, sauf pour certains paquets dits "d'accès" qui ne sont pas complètement synchronisés.

La présente invention a pour objet un dispositif de commande de gain dans un récepteur de signaux d'information comprenant, comme dans le premier dispositif connu :
- une entrée de signal recevant un signal d'information d'entrée,
- des moyens d'amplification à facteur d'amplification ajustable couplés à cette entrée pour recevoir le signal d'information d'entrée et en modifier le niveau en fonction d'un signal de commande de gain reçu sur une entrée de commande de gain, de manière à en dériver un signal d'information de sortie,
- une sortie de signal couplée aux moyens d'amplification et fournissant un signal d'information de sortie, mais ne souffrant pas des inconvénients ou limitations mentionnés.

Le dispositif de commande de gain de la présente invention se caractérise en ce qu'il comprend en outre :
- des moyens d'évaluation couplés à cette entrée pour recevoir le signal d'information d'entrée et en dériver un signal d'amplitude dépendant du niveau de ce dernier signal,
- des moyens de traitement couplés aux moyens d'évaluation, recevant le signal d'amplitude et en dérivant un signal de commande de gain selon une loi de commande de gain définie, lequel est transmis à l'entrée de commande de gain des moyens d'amplification,
ces moyens étant agencés de sorte que le niveau du signal d'information de sortie possède une dynamique réduite par rapport à celle du signal d'information d'entrée.

Le signal d'information d'entrée est avantageusement un signal en provenance de stations distantes transmettant chacune dans un intervalle de temps qui leur est propre dans une trame répétitive, conformément au système connu dit à "Accès Multiple à Répartition dans le Temps" (AMRT), les moyens de traitement répondant à un signal de synchronisation lié à la base de temps du système AMRT.

Préférentiellement, les moyens de traitement délivrent un signal de commande de gain constant pendant sensiblement la totalité de chaque intervalle de temps.

On obtient ainsi un signal d'information de sortie constitué d'intervalles de temps successifs ayant chacun sensiblement la même amplitude.

Avantageusement, chaque intervalle de temps comporte un préambule de durée relativement courte sur lequel est effectuée l'évaluation de niveau par les moyens d'évaluation et le traitement correspondant par les moyens de traitement, de sorte qu'un signal de commande de gain soit disponible sensiblement au début d'un paquet d'information transmis dans cet intervalle de temps à la suite de ce préambule.

Dans un autre mode de réalisation, chaque intervalle de temps est divisé en tranches temporelles, chacune de durée prédéterminée, et l'évaluation du niveau de signal par les moyens de traitement dans chacune de ces tranches temporelles détermine le réglage du gain dans la tranche temporelle suivante.

Les moyens d'évaluation sont avantageusement constitués par un détecteur d'enveloppe.

De préférence, le dispositif de commande de gain de l'invention comprend en outre des moyens de retard interposés entre le point de couplage et les moyens d'amplification, ces moyens de retard fournissant aux moyens d'amplification un signal d'information d'entrée retardé d'un temps tel que le signal de commande de gain est disponible pour la commande de gain dans les moyens d'amplification au moment où ceux-ci reçoivent le signal d'information d'entrée retardé.

De plus, le dispositif de commande de gain de l'invention comprend un filtre agencé pour que le signal d'information d'entrée soit filtré avant d'être fourni aux moyens d'évaluation, par un filtre passe-bande ou par un filtre passe-bas. Ce filtre est interposé soit entre l'entrée de signal et le point de couplage, soit entre le point de couplage et les moyens d'évaluation.

Dans une forme de réalisation des moyens d'amplification, ceux-ci comprennent un atténuateur variable au moins, dont l'atténuation est commandée par le signal de commande de gain.

D'autres caractéristiques et avantages de l'invention apparaîtront à la lecture de la description suivante d'un mode de réalisation, donné à titre illustratif et non limitatif, et des figures annexées qui représentent :
- la figure 1, la situation de stations mobiles par rapport à une station fixe, dans un système de type AMRT,
- la figure 2, la trame AMRT reçue par la station fixe dans le cas de la figure 1,
- la figure 3, un mode de réalisation du dispositif de commande de gain pour un récepteur de signaux d'information de la présente invention, ce mode de réalisation incluant des variantes.

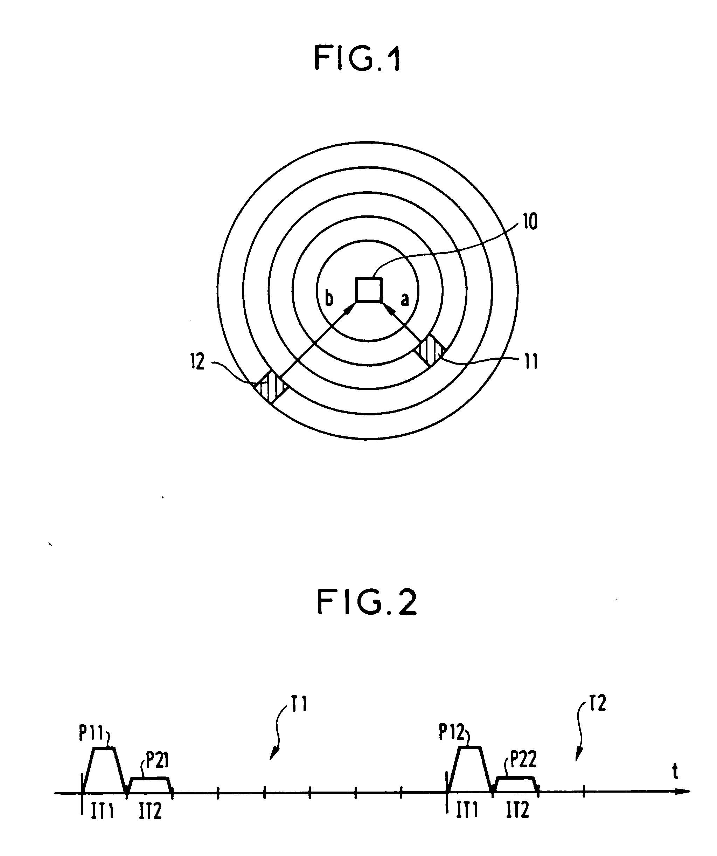

La figure 1 représente un système de transmission incluant une station de base fixe 10 et deux stations mobiles 11 et 12 situées à des distances différentes a et b de la station de base 10. L'ensemble peut appartenir, par exemple, à un réseau radiotéléphonique de type GSM.

Dans ce qui suit, on ne traitera que de la transmission des stations mobiles 11, 12 vers la station fixe 10. La transmission des stations mobiles 11, 12 vers la station fixe 10 a lieu par paquets dans une trame d'intervalles de temps répétitifs, tel que représenté à la figure 2 où l'on a représenté une trame T1, composée d'intervalles de temps consécutifs IT1, IT2, etc., et le début d'une trame T2 où l'on retrouve ces intervalles de temps IT1 et IT2. Dans le premier des intervalles de temps IT1 de la trame T1, la station mobile 11 transmet un paquet P11, tandis que, dans l'intervalle de temps IT2, la station mobile 12 transmet le paquet P21. Dans le premier intervalle de temps IT1 de la trame T2, la station mobile 11 transmet un nouveau paquet P12, lequel est suivi d'un paquet P22 transmis par la station mobile 12, et ainsi de suite.

Chaque paquet transmis est en fait un signal à une fréquence allouée à la communication entre les stations mobiles considérées et la station fixe, modulé par l'information à transmettre, information numérique dans le cas d'un système de type GSM.

La figure 2 représente les signaux tels qu'ils sont reçus par la station fixe. Des dispositions dont on ne traitera pas ici, car elles sont étrangères à la présente invention, peuvent être employées afin que la position temporelle des paquets qui se suivent soit définie de façon appropriée à leur arrivée dans la station fixe.

Le point important, en ce qui concerne la présente invention, est que les paquets reçus de différentes stations mobiles ont des amplitudes variées. La station mobile 11 est en effet relativement proche de la station fixe 10. L'amplitude du signal que reçoit la station fixe 10, dans l'intervalle de temps IT1, est donc relativement importante. Par comparaison, la station mobile 12 est plus éloignée et l'amplitude du signal que reçoit la station fixe 10, dans l'intervalle de temps IT2, est relativement faible.

La distance n'est bien sûr pas le seul facteur qui intervienne dans l'amplitude des signaux reçus par la station fixe 10; on peut encore citer la présence d'obstacles à la propagation, l'évanouissement dû aux trajets multiples, etc...

La réception de signaux ayant ainsi une forte dynamique pose un problème de réduction de cette dynamique, avant que ces signaux ne soient exploités, par exemple pour recouvrer l'information analogique ou numérique qu'ils contiennent. En effet, ces signaux devront traverser des circuits comprenant des composants actifs, des transistors notamment, dont la réponse en amplitude n'est pas linéaire. Ainsi, des signaux trop faibles risquent de ne pouvoir être exploités, tandis que des signaux trop forts risquent d'être déformés par saturation, ce qui peut entraîner une perte d'information.

Il y a donc lieu de procéder à une amplification suffisante des signaux faibles, et à une moindre amplification des signaux forts, c'est-à-dire à une réduction de la dynamique des signaux d'entrée du récepteur.

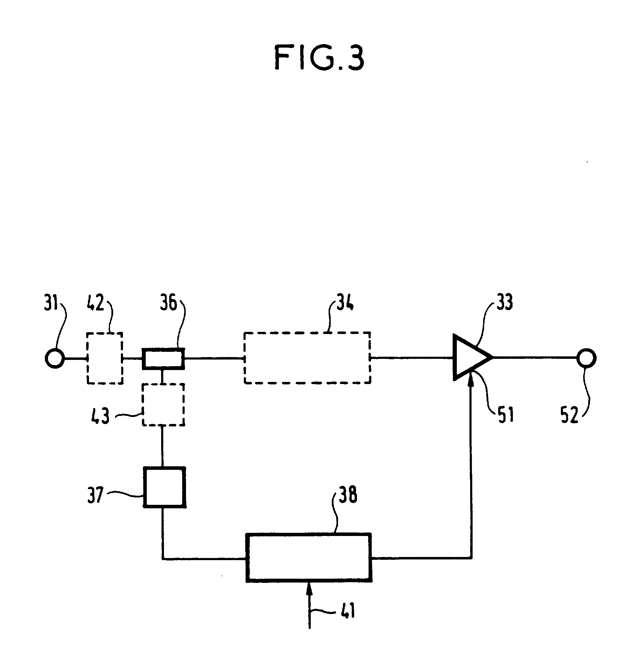

L'invention propose des moyens à cette fin, dont la figure 3 représente un exemple de réalisation.

La figure 3 représente un dispositif de commande de gain destiné à être utilisé dans un récepteur de signaux d'information non représenté. Ce dispositif comprend:
- une entrée de signal 31 recevant un signal d'information d'entrée,
- des moyens d'amplification à facteur d'amplification ajustable 33 couplés à l'entrée 31 pour recevoir le signal d'information d'entrée et en modifier le niveau en fonction d'un signal de commande de gain reçu sur une entrée de commande de gain 51, de manière à en dériver un signal d'information de sortie,
- une sortie de signal 52 couplée aux moyens d'amplification 33 et fournissant le signal d'information de sortie,
- des moyens d'évaluation 37 couplés à l'entrée 31 pour recevoir le signal d'information d'entrée et en dériver un signal d'amplitude dépendant du niveau de ce dernier signal,
- des moyens de traitement 38 couplés aux moyens d'évaluation 37, recevant le signal d'amplitude et en dérivant un signal de commande de gain selon une loi de commande de gain définie, lequel est transmis à l'entrée de commande de gain 51 des moyens d'amplification 33.

La figure 3 représente en outre un coupleur 36 prélevant le signal d'information d'entrée de la branche comprenant les moyens d'amplification 33 pour le fournir à celle qui contient les moyens d'évaluation 37 et de traitement 38.

Les moyens d'évaluation 37 peuvent être un simple détecteur d'enveloppe, tandis que les moyens de traitement 38 peuvent prendre diverses formes, comme cela apparaîtra plus loin.

Les moyens d'amplification 33 à facteur d'amplification ajustable peuvent prendre la forme d'une chaîne d'étages d'amplification dans laquelle sont intercalés des étages d'atténuation commandables. Dans ce cas, le gain est ajusté par commande d'atténuateurs.

Ces différents moyens sont agencés de sorte que le niveau du signal d'information de sortie possède une dynamique réduite par rapport à celle du signal d'information d'entrée tel qu'il est illustré à la figure 2. Le signal d'information d'entrée étant celui de la figure 2, le signal d'information de sortie est un signal semblable mais tel que la différence entre les amplitudes des paquets P11, P12 et P21, P22 soit réduite. Pour y parvenir, les moyens d'évaluation 37 déterminent l'amplitude du signal d'entrée, cette amplitude faisant l'objet d'un traitement dont il sera question plus loin dans les moyens de traitement 38, lesquels produisent le signal de commande de gain.

Appliqué à l'entrée de commande de gain 51 des moyens d'amplification 33, ce signal de commande de gain détermine l'amplification plus ou moins importante du signal d'information d'entrée et procure l'effet recherché de réduction de la dynamique de ce signal, les moyens d'amplification 33 fournissant ainsi un signal d'information de sortie à dynamique réduite sur la sortie 52.

Dans le dispositif de commande de gain de la figure 3, les moyens de traitement 38 peuvent être aménagés pour répondre à un signal de synchronisation d'intervalle de temps, produit par une base de temps non représentée et appliqué sur une entrée de synchronisation 41, pour fonctionner sur la base de l'intervalle de temps et maintenir le même réglage de gain pendant sensiblement la totalité de chaque intervalle de temps. Par exemple, les moyens de traitement 38 peuvent observer l'amplitude maximale ou moyenne du signal pendant l'intervalle de temps IT1 de la trame T1 de la figure 2, pour déterminer un signal de commande de gain qui sera appliqué et maintenu à l'entrée de commande de gain 51 durant tout l'intervalle de temps IT1 de la trame T2, et ainsi de suite, trame après trame et pour chaque intervalle de temps. Cela suppose évidemment que le niveau du signal reçu d'une station mobile ne se modifie pas sensiblement entre deux trames consécutives.

Selon un autre exemple, le paquet peut comprendre un préambule de durée relativement courte sur lequel est effectuée l'évaluation de niveau par les moyens d'évaluation 37 et le traitement correspondant par les moyens de traitement 38, de sorte qu'un signal de commande de gain soit disponible sensiblement au début d'un paquet d'information transmis dans un intervalle de temps, signal de commande de gain qui est ensuite maintenu durant tout l'intervalle de temps. Il est supposé, dans cet autre cas, que le préambule considéré ne devra pas être traité dans des circuits nécessitant une dynamique réduite, qu'il est par exemple réservé au réglage du gain pour le reste du paquet.

Selon une solution mixte possible, le signal reçu dans un intervalle de temps donné est divisé en tranches temporelles, chacune de durée prédéterminée, et l'évaluation du niveau dans chaque tranche détermine le réglage du gain dans la tranche temporelle suivante.

Selon un mode de réalisation préféré, le dispositif de commande de gain de l'invention comprend en outre des moyens de retard 34, représentés en traits discontinus à la figure 3 en raison de leur caractère optionnel; ils sont interposés entre le coupleur 36 et les moyens d'amplification 33 et fournissent à ces moyens d'amplification 33 un signal d'information d'entrée retardé d'un temps tel que le signal de commande de gain est disponible pour la commande de gain dans les moyens d'amplification 33 au moment où ceux-ci reçoivent le signal d'information d'entrée retardé.

Une telle disposition, dans tous les cas de commande de gain envisagés antérieurement, permet d'effectuer l'évaluation de l'amplitude du signal d'information d'entrée, dans les moyens d'évaluation 37, puis le traitement de l'amplitude dans les moyens de traitement 38, en y consacrant tout le temps nécessaire, temps durant lequel le signal d'entrée franchit les moyens de retard 34. Alors, au moment où le paquet ou, plus généralement, le signal d'information reçu dans un intervalle de temps atteint les moyens d'amplification 33, le signal de commande de gain est fourni sur leur entrée de commande de gain 51 par les moyens de traitement 38, de sorte que ce signal pourra s'appliquer dès le début du signal d'information à partir duquel il a été établi. Il est ainsi possible d'ajuster l'amplitude de tout un paquet à partir d'un ou de plusieurs échantillons quelconques du paquet, prélevés, évalués et traités avant que le paquet n'atteigne les moyens d'amplification 33.

Dans un mode de réalisation préféré, l'évaluation du niveau de réception d'un paquet aura lieu dans un échantillon prélevé après un court laps de temps en début de paquet, d'une durée suffisante pour permettre l'élimination de parasites par intégration, procurant ainsi un signal de commande de gain servant à ajuster l'amplitude de la totalité du signal reçu dans cet intervalle de temps.

Le retard apporté par les moyens de retard 34 pourra prendre n'importe quelle valeur pourvu qu'elle excède la durée nécessaire pour la réception de l'échantillon du paquet servant à l'évaluation, augmentée de la durée nécessaire pour le fonctionnement des circuits de traitement 38 et la commande de gain dans les moyens d'amplification 33.

Par ailleurs, la figure 3 représente également des moyens de filtrage 42 et 43, représentés en traits discontinus en raison de leur caractère également optionnel.

En effet, le signal d'information d'entrée comprendra dans certain cas des signaux parasites hors bande qui affecteraient l'évaluation d'amplitude s'ils n'étaient pas éliminés. La solution est de les filtrer, par un filtrage passe-bande ou passe-bas.

On peut insérer un tel filtre (42) entre l'entrée 31 et le point de couplage 36. Une autre solution consiste en l'insertion d'un filtre (43) dans la branche d'évaluation seulement. En effet, le seul respect de l'information d'amplitude impose des spécifications bien moins sévères du filtre que dans la solution précédente et un tel filtre 43 sera donc moins coûteux.

On mentionnera enfin que bien que l'on ait parlé depuis le début de la description de moyens d'amplification à facteur d'amplification ajustable, une solution avantageuse pour la réalisation de tels moyens d'amplification consiste en une chaîne d'amplificateurs comprenant un atténuateur variable au moins, dont l'atténuation est commandée par le signal de commande de gain. On peut ainsi employer en particulier des atténuateurs commandables acceptant, sans apporter eux-mêmes de distorsion, la dynamique encore importante du signal d'entrée.

## Revendications

1. Dispositif de commande de gain dans un récepteur de signaux d'information comprenant :
- une entrée de signal (31) recevant un signal d'information d'entrée,
- des moyens d'amplification (33) à facteur d'amplification ajustable couplés à ladite entrée (31) pour recevoir ledit signal d'information d'entrée et en modifier le niveau en fonction d'un signal de commande de gain reçu sur une entrée de commande de gain (51), de manière à en dériver un signal d'information de sortie,
- une sortie de signal (52) couplée auxdits moyens d'amplification (33) et fournissant ledit signal d'information de sortie,
caractérisé en ce qu'il comprend en outre :
- des moyens d'évaluation (37) couplés à ladite entrée (31) par un point de couplage (36) pour recevoir ledit signal d'information d'entrée et en dériver un signal d'amplitude dépendant du niveau de ce dernier signal,
- des moyens de traitement (38) couplés auxdits moyens d'évaluation (37), en recevant ledit signal d'amplitude et en dérivant un signal de commande de gain selon une loi de commande de gain définie, lequel est transmis à ladite entrée de commande de gain (51) desdits moyens d'amplification (33),
ces moyens (37, 38) étant agencés de sorte que le niveau dudit signal d'information de sortie possède une dynamique réduite par rapport à celle dudit signal d'information d'entrée.

2. Dispositif selon la revendication 1, caractérisé en ce que ledit signal d'information d'entrée est un signal en provenance de stations (11, 12) distantes transmettant chacune dans un intervalle de temps qui leur est propre dans une trame répétitive, conformément au système connu dit à "Accès Multiple à Répartition dans le Temps" (AMRT), lesdits moyens de traitement (38) répondant à un signal de synchronisation (41) lié à la base de temps du système AMRT.

3. Dispositif selon la revendication 2, caractérisé en ce que lesdits moyens de traitement (38) délivrent un signal de commande de gain constant pendant sensiblement la totalité de chaque intervalle de temps.

4. Dispositif selon la revendication 2, caractérisé en ce que chaque intervalle de temps comporte un préambule de durée relativement courte sur lequel est effectuée l'évaluation de niveau par lesdits moyens d'évaluation (37) et le traitement correspondant par lesdits moyens de traitement (38), de sorte qu'un signal de commande de gain soit disponible sensiblement au début d'un paquet d'information transmis dans cet intervalle de temps à la suite dudit préambule.

5. Dispositif selon la revendication 2, caractérisé en ce que chaque intervalle de temps est divisé en tranches temporelles, chacune de durée prédéterminée, et en ce que l'évaluation du niveau de signal par lesdits moyens de traitement (38) dans chacune desdites tranches temporelles détermine le réglage du gain dans la tranche temporelle suivante.

6. Dispositif selon l'une des revendications 1 à 5, caractérisé en ce que lesdits moyens d'évaluation (37) sont constitués par un détecteur d'enveloppe.

7. Dispositif selon l'une des revendications 1 à 6, caractérisé en ce qu'il comprend en outre des moyens de retard (34) interposés entre ledit point de couplage (36) et lesdits moyens d'amplification (33), lesdits moyens de retard (34) fournissant auxdits moyens d'amplification (33) un signal d'information d'entrée retardé d'un temps tel que ledit signal de commande de gain est disponible pour la commande de gain dans lesdits moyens d'amplification (33) au moment où ceux-ci reçoivent ledit signal d'information d'entrée retardé.

8. Dispositif selon l'une des revendications 1 à 7, caractérisé en ce qu'il comprend un filtre (42, 43) agencé pour que ledit signal d'information d'entrée soit filtré avant d'être fourni auxdits moyens d'évaluation (37).

9. Dispositif selon la revendication 8, caractérisé en ce que ledit filtre (42, 43) est un filtre passe-bande.

10. Dispositif selon la revendication 8, caractérisé en ce que ledit filtre (42, 43) est un filtre passe-bas.

11. Dispositif selon l'une des revendications 9 et 10, caractérisé en ce que ledit filtre (42) est interposé entre ladite entrée de signal (31) et ledit point de couplage (36).

12. Dispositif selon l'une des revendications 9 et 10, caractérisé en ce que ledit filtre (43) est agencé entre ledit point de couplage (36) et lesdits moyens d'évaluation (37).

13. Dispositif selon l'une des revendications 1 à 12, caractérisé en ce que lesdits moyens d'amplification (33) comprennent un atténuateur variable au moins, dont l'atténuation est commandée par ledit signal de commande de gain.

## Patentansprüche

1. Vorrichtung zur Verstärkungssteuerung in einem Empfänger von Informationssignalen,
- mit einem Signaleingang (31), an dem ein Eingangsinformationssignal ankommt,
- mit Verstärkungsmitteln (33), deren Verstärkungsfaktor einstellbar ist und die an diesen Eingang (31) gekoppelt sind, um das Eingangsinformationssignal zu empfangen und dessen Pegel abhängig von einem Verstärkungsgradsteuersignal zu verändern, das auf einem Verstärkungssteuereingang (51) empfangen wird, so daß sich ein Ausgangsinformationssignal ergibt,
- mit einem Signalausgang (52), der an die Verstärkungsmittel (33) gekoppelt ist und ein Ausgangsinformationssignal liefert,
dadurch gekennzeichnet, daß die Vorrichtung weiter aufweist:
- Auswertemittel (37), die an den Eingang (31) über einen Koppelpunkt (36) gekoppelt sind und das Eingangsinformationssignal empfangen sowie daraus ein Amplitudensignal ableiten, dessen Amplitude vom Pegel des Eingangssignals abhängt,
- Verarbeitungsmittel (38), die an die Auswertemittel (37) gekoppelt sind, von diesen das Amplitudensignal empfangen und daraus ein Verstärkungsgradsteuersignal gemäß einem definierten Verstärkungsgradsteuergesetz ableiten, das dann an den Verstärkungsgradsteuereingang (51) der Verstärkungsmittel (33) gelangt,
wobei diese Mittel (37, 38) so ausgebildet sind, daß der Pegel des Ausgangsinformationssignals eine verringerte Dynamik im Vergleich zu der des Eingangsinformationssignals besitzt.

2. Vorrichtung nach Anspruch 1, dadurch gekennzeichnet, daß das Eingangsinformationssignal ein Signal ist, das von entfernten Stationen (11, 12) kommt, die gemäß dem bekannten TDMA-System (Zeitmultiplex mit Mehrfachzugang) je in einem Zeitintervall senden, das ihnen in einem Wiederholrahmen zugewiesen ist, wobei die Verarbeitungsmittel (38) auf ein Synchronisationssignal (41) ansprechen, das mit der Zeitbasis des TDMA-Systems verknüpft ist.

3. Vorrichtung nach Anspruch 2, dadurch gekennzeichnet, daß die Verarbeitungsmittel (38) ein konstantes Verstärkungsgradsteuersignal während im wesentlichen jedes ganzen Zeitintervalls liefern.

4. Vorrichtung nach Anspruch 2, dadurch gekennzeichnet, daß jedes Zeitintervall einen relativ kurzen Vorspann enthält, in dem die Pegelauswertung durch die Auswertemittel (37) und die entsprechende Verarbeitung durch die Verarbeitungsmittel (38) erfolgen, so daß ein Verstärkungsgradsteuersignal im wesentlichen zu Beginn eines in diesem Zeitintervall nach dem Vorspann übermittelten Informationspakets verfügbar ist.

5. Vorrichtung nach Anspruch 2, dadurch gekennzeichnet, daß jedes Zeitintervall in Zeitabschnitte unterteilt ist, die je eine vorbestimmte Dauer besitzen, und daß die Auswertung des Signalpegels durch die Verarbeitungsmittel (38) in jedem Zeitabschnitt die Verstärkungsgradregelung in dem nächstfolgenden Zeitabschnitt bestimmt.

6. Vorrichtung nach einem der Ansprüche 1 bis 5, dadurch gekennzeichnet, daß die Auswertemittel (37) von einem Hüllkurvendetektor gebildet werden.

7. Vorrichtung nach einem der Ansprüche 1 bis 6, dadurch gekennzeichnet, daß sie weiter Verzögerungsmittel (34) aufweist, die zwischen den Koppelpunkt (36) und die Verstärkungsmittel (33) eingefügt sind und an die Verstärkungsmittel (33) ein um eine solche Dauer verzögertes Eingangsinformationssignal liefern, daß das Verstärkungsgradsteuersignal für die Verstärkungssteuerung in den Verstärkungsmitteln (33) verfügbar ist, wenn diese das verzögerte Eingangsinformationssignal empfangen.

8. Vorrichtung nach einem der Ansprüche 1 bis 7, dadurch gekennzeichnet, daß sie ein Filter (42, 43) enthält, das so ausgebildet ist, daß das Eingangsinformationssignal gefiltert wird, ehe es an die Auswertemittel (37) geliefert wird.

9. Vorrichtung nach Anspruch 8, dadurch gekennzeichnet, daß das Filter (42, 43) ein Bandpaßfilter ist.

10. Vorrichtung nach Anspruch 8, dadurch gekennzeichnet, daß das Filter (42, 43) ein Tiefpaßfilter ist.

11. Vorrichtung nach einem der Ansprüche 9 und 10, dadurch gekennzeichnet, daß das Filter (42) zwischen dem Signaleingang (31) und dem Koppelpunkt (36) liegt.

12. Vorrichtung nach einem der Ansprüche 9 und 10, dadurch gekennzeichnet, daß das Filter (43) zwischen dem Koppelpunkt (36) und den Auswertemitteln (37) liegt.

13. Vorrichtung nach einem der Ansprüche 1 bis 12, dadurch gekennzeichnet, daß die Verstärkungsmittel (33) mindestens ein variables Dämpfungsglied enthalten, dessen Dämpfung durch das Verstärkungssteuersignal gesteuert wird.

## Claims

1. Gain control device in a data signal receiver comprising:
- a signal input (31) receiving an input data signal,
- variable gain amplifier means (33) coupled to said input (31) to receive said input data signal and adapted to modify its level according to a gain control signal received at a gain control input (51) so as to derive therefrom an output data signal, and
- a signal output (52) coupled to said amplifier means (33) and supplying said output data signal,
characterised in that it further comprises:
- evaluator means (37) coupled to said input (31) by a coupling point (36) to receive said input data signal and adapted to derive therefrom an amplitude signal dependent on the level of the latter signal, and
- processor means (38) coupled to said evaluator means (37), receiving therefrom said amplitude signal and deriving therefrom a gain control signal according to a predefined gain control law, which signal is sent to said gain control input (51) of said amplifier means (33),
said means (37, 38) being such that the level of said output data signal has a dynamic range reduced as compared with that of said input data signal.

2. Device according to claim 1 characterised in that said input data signal is a signal from remote stations (11, 12) each sending a respective time slot in a repetitive time-division multiple access (TDMA) frame, said processor means (38) responding to a synchronisation signal (41) related to the TDMA clock.

3. Device according to claim 2 characterised in that said processor means (38) produce a constant gain control signal during substantially all of each time slot.

4. Device according to claim 2 characterised in thai each time slot includes a relatively short preamble during which the level is evaluated by said evaluator means (37) and the respective processing is carried out by said processor means (38) so that a gain control signal is available substantially at the start of a data packet sent in this time slot after said preamble.

5. Device according to claim 2 characterised in that each time slot is divided into time slices each of predetermined duration and in that the evaluation of the signal level by said processor means (38) in each of said time slices determines the gain setting for the next time slice.

6. Device according to any one of claims 1 to 5 characterised in that said evaluator means (37) comprise an envelope detector.

7. Device according to any one of claims 1 to 6 characterised in that it further comprises time-delay means (34) between said coupling point (36) and said amplifier means (33), said time-delay means (34) supplying to said amplifier means (33) an input data signal delayed by an amount such that said gain control signal is available for controlling the gain in said amplifier means (33) when the latter receive said delayed input data signal.

8. Device according to any one of claims 1 to 7 characterised in that it comprises a filter (42, 43) by which said input data signal is filtered before it is supplied to said evaluator means (37).

9. Device according to claim 8 characterised in that said filter (42, 43) is a band-pass filter.

10. Device according to claim 8 characterised in that said filter (42, 43) is a low-pass filter.

11. Device according to claim 9 or claim 10 characterised in that said filter (42) is disposed between said signal input (31) and said coupling point (36).

12. Device according to claim 9 or claim 10 characterised in that said filter (43) is disposed between said coupling point (36) and said evaluator means (37).

13. Device according to any one of claims 1 to 12 characterised in that said amplifier means (33) comprise at least one variable attenuator the attenuation of which is controlled by said gain control signal.
